# EUROPEAN PATENT APPLICATION

(11) **EP 3 573 237 A1**
(43) Date of publication of application: **27.11.2019**
(21) Application number: 19175275.7
(22) Date of filing: 19.05.2019
(51) Int. Cl.: H03K 17/96, F21V 8/00, H05K 3/00

(54) **SET OF PLATES OF ELECTRONIC MULTICHANNEL TOUCH WALL SWITCH**

(30) Priority: 22.05.2018 PL 42566318
(71) Applicant: Lesniak, Wojciech, 04-035 Warszawa (PL)
(72) Inventor: Lesniak, Wojciech, 04-035 Warszawa (PL)

(57) **Abstract**

The essence of a set according to the invention consisting of a connection terminals board **6** with power commutation switches **37** and power supply unit **Z,** microprocessor main board with microprocessor **5,** fitting bridge **4,** decorative masking frame **3,** sensors board **2** with LED diodes **D** and their controller **25**, touch-proximity sensors **SZ** with their controller **24** as well as ambient light and rangefinder sensor module **MS,** light guide plate **8** with back reflective layer **9** and front dielectric graphic layer with backlighted icons **10,** which said elements have the means to combine them together consists in the fact that, the light guide plate **8** is divided by a slots creating a light guide cells **13,** where said slots are filled with reflective material creating the side walls **14** of the light guide cells **13,** whereby so constructed light guide plate **8** is integrated with back reflective layer **9** and front dielectric backlighted graphic layer **7** creating in turn a solid fiber optic light guide panel **1,** which along with the sensors board **2** are inserted into window **38** of the decorative masking frame **3.** Furthermore, sensors board (**2**) contains infrared light receiver **SP** module and ambient light sensor **MS** integrated with the rangefinder made as a single integrated module using infrared wavelength band, whereas the main microprocessor board **5** has breakable perforated side outlets **31** with mounting holes **32** and **33** facilitating the installation of the microprocessor **5** board to the decorative masking frame **5.** The microprocessor main board **5** has an extension connector **29** for communication with external devices as well as a radio communication module **M.**

## Description

The presented invention relates to a set of boards of a wall switch for electrical appliances with touch or proximity sensors and backlighted icons.

### Description

There are known commercially available wall switches consisting of printed circuit board, set of light guide extruded shapes, front plate with graphic icons centered above a touch-proximity of the finger, steel fastening bridge, masking frame, ambient light sensor as well an electroluminescent LED diodes and the others necessary elements. Above mentioned plates, boards and layers are joined together permanently using a glue or mechanically creating abovementioned solid set. Due to a mechanical structure of know extruded light guide shapes in previous and present solutions, distances between LED diodes and light guide shapes used for backlighting of graphic icons on front plate have to be wide enough to ensure that each light guide plate with accompanying LED diode is exclusively backlighting only corresponding graphic icon localized above, excluding adjacent icons forcing of keeping wide separation gaps between light guide shapes.

Widely know on present market and for instance presented on the web page *http:*//*livolopolska.com* the wall switches manufactured by LIVOLO, comprise front plate with only two graphic icons indicating locations of each touch area and only four LED diodes soldered on back Printed Circuit Board, two per each extruded light guide shape backlighting the dedicated icon to be backlighted. Increasing the number of icons and therefore the number of serviced electrical channels or electric receivers forces of using an additional wall switches by mounting several such an abovementioned two channel switches in row, which occupies far more space on the wall. Furthermore the LIVOLO offer of touch wall switches with replaceable decorative front frames is limited to very small number of colors, sizes and surface textures offered by the manufacturer, restricting and hindering the possibilities of interior design.

Increasing the number of decorative frames combinations, would force manufacturing many very expensive injection molds for each type of decorative masking frame, causing final product price drastically increased. Despite there are plenty of decorative masking frames for wall switches and mounting bridges available commercially from many many manufacturers on the market today, there is no possibility to combine them creating different combinations, because sizes and mounting style of particular decorative masking frame fits only also particular type of wall switch of the same manufacturer as well there is a total lack of market standardization in this matter, that is no mechanical compatibility among the wall switches and its components and parts from different manufacturers.

At present market state, it is not known on the market such a set of boards of touch wall switch module, allowing embedding the electronics in set of printed circuit boards into decorative masking frame of any manufacturer of any shape of any surface texture or any material all at once, which would frees the manufacturer of such a new touch wall switch from the necessity to invest in expensive casting or injection molds.

The purpose of the presented invention was a creation of possibility of controlling more electrical receivers by finding the way how to increase the number of individually backlighted graphic icons without the needs of increasing mechanical dimensions of touch wall switch panel and simultaneously preventing leaking of the light which backlights one icon towards adjacent icons, enabling cooperation the new touch wall switch with any commercially available home control system of any manufacturer, especially of Smart Home market as well as significant new touch wall switch manufacturing cost reductions and simultaneously extending possibilities of usage a different combinations of colors, mechanical proportions, sizes and textures of decorative masking frames and front icon plates.

The essence of the set of boards according to the invention - composed of terminals board with power commutation switches and power supply unit, main microprocessor board, fitting bridge, decorative masking frame, sensors board comprising touch or proximity sensors with their controller and set of electroluminescent LED diodes with their controller as well as passive sensors namely ambient light sensor and infrared light sensor, light guide plate with back reflective layer and front dielectric layer with backlighted graphic icons and all the above mentioned elements having an interconnection means - is that the light guide plate is divided by a gaps, slits or slots creating required number of separate light guide cells and each gap is filled with reflective material creating the side walls of the light guide cells, whereby so constructed light guide plate is stacked with back reflective layer and front dielectric backlighted graphic layer as a solid fiber optic light guide panel, which along with the sensors board is inserted into decorative masking frame window. Furthermore sensors board contains an infrared light receiver module acquiring the remote control signals and the ambient light sensor integrated with the rangefinder made as a single integrated module using infrared wavelength band. The main microprocessor board has breakable perforated side outlets with mounting holes facilitating the installation of microprocessor board in known commercially available mounting bridge, whereby the sensors board and backlighted light guide panel have an identical shape and outer size adjusted to the window of the decorative masking frame of any choice. It is preferable that the microprocessor board has an extension connector for communication with external devices as well as a radio communication module and a electroluminescent LED diodes on sensor's board are tricolor LEDs.

One of the benefits of such a solution presented herein is a possibility of significant increasing the number of light cells and so the number of controlled electric appliances while keeping small size of the front backlighted light guide panel and the touch-proximity sensors board. Second and most important advantage is a possibility of using variety of decorative masking frames and mounting bridges already available on the market, so that the needs of manufacturing various variants of injection molds with their very high costs are eliminated. It is achievable mainly due to breakable perforated side outlets on microprocessor bard which allow mounting the whole boards stackup as well as the size adaptations of abovementioned boards and light guide panels to wide choice of known elements available on the market. The rangefinder allows sensing the human hand approaching towards the front touch panel, which is advantageous when the hand "search" the touch panel in the dark for instance. Immediately after hand detection, the presented invented touch wall switch can backlight the panel for more comfortable usage. Furthermore, the external communication connector incorporated in the set according to the presented invention allows connecting and integrating the new touch wall switch with external devices and whole third-party control systems of any manufacturer for instance of Smart Home market and no known commercially available wall switch on the market offers it at present. Despite the presented below a physical realization example of the invention has only six touch-proximity sensors, it is possible not only to issue a six On/Off commands for each channel but thanks to touch time period measurement implementation in the microprocessor firmware, the presented touch wall switch has gained an ability to execute many more additional utility functions like household persons simulation, delayed switching off the channels and so on. As an example, when a child is afraid to fall asleep in the dark, the wall switch will maintain the light On and then will turn the light Off after the predefined time period. Bye the specified touch time length of any touch sensor **SP** on the front panel, this user activity may cause a broadcast network message to other presented touch wall switches cooperating in the local network resulting in a different actions on the remote associated device, which is important for instance when arranging the light scenes. Also the use of tricolor RGB electroluminescent LED diodes **D** instead of single color diodes along with the supervising dedicated LED controller, enabled dynamically changing the backlight color and intensity as well as to enrich the graphic icons backlighting in any desirable color, which in turn allows the device to communicate interactively with the user by color coded messages and informing the user about the device internal state or working mode of any particular touch pad and channel.

The presented invented touch wall switch has been shown on drawings below illustrating the manufacturing realization examples, where:

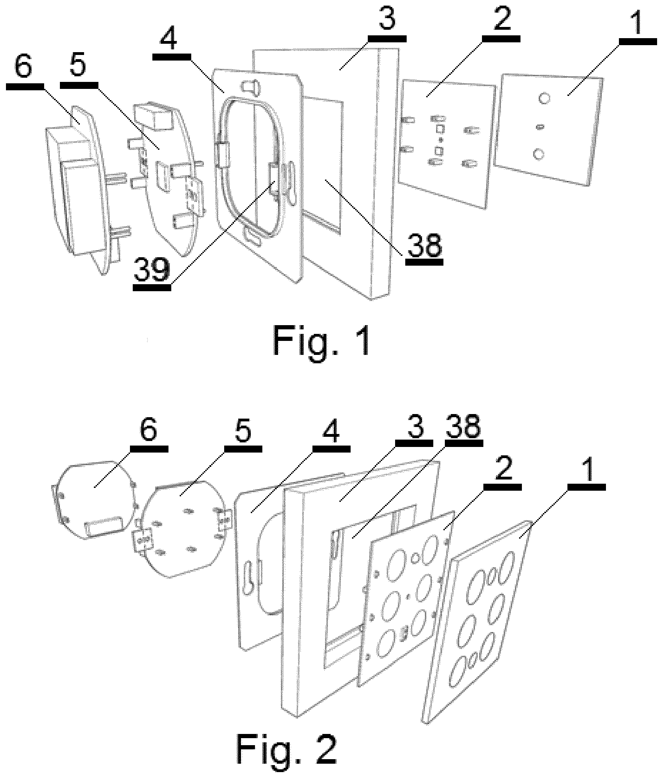

- Fig. 1 -: shows perspective back view of the switch module subject of description,
- Fig. 2 -: shows perspective front view of the switch module subject of description,

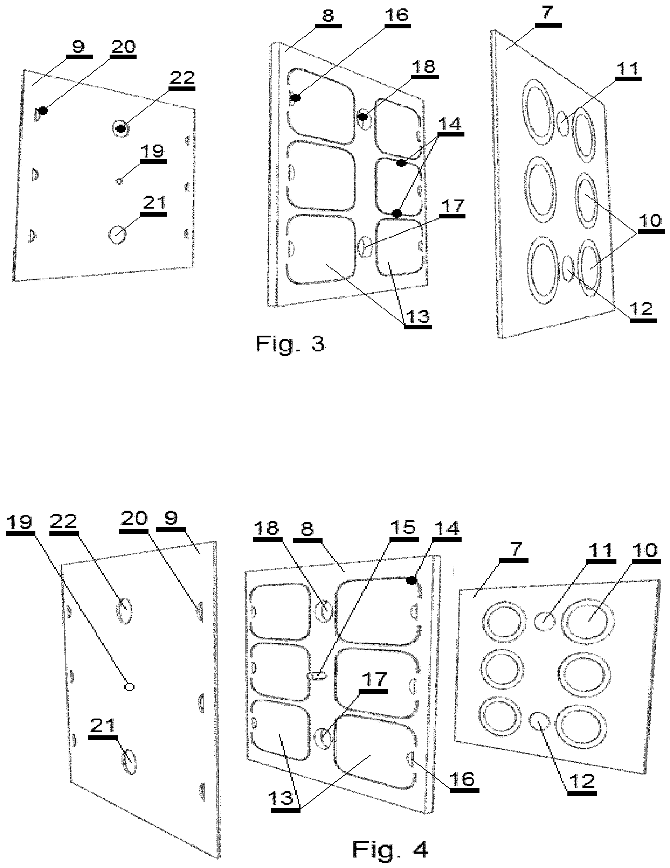

- Fig. 3 -: shows delaminated light guide backlight panel as a perspective front view,
- Fig. 4 -: shows delaminated light guide backlight panel as a perspective back view,

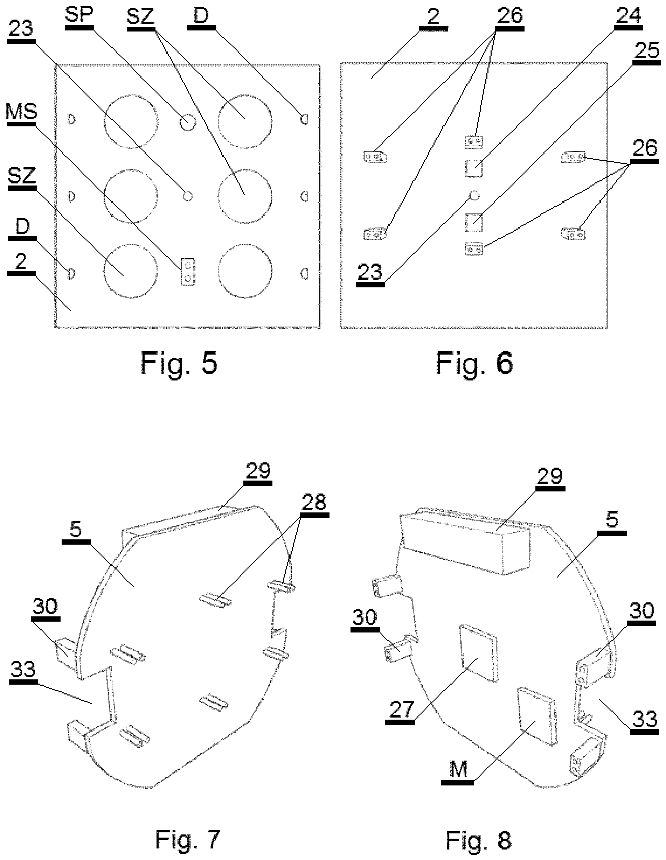

- Fig. 5 -: shows a sensors board front view,
- Fig. 6 -: shows the sensors board back view,
- Fig. 7 -: shows perspective front view of microprocessor board with side inlets prior to combining with mounting bridge,
- Fig. 8 -: shows perspective back view of microprocessor board with side inlets prior to combining with mounting bridge,

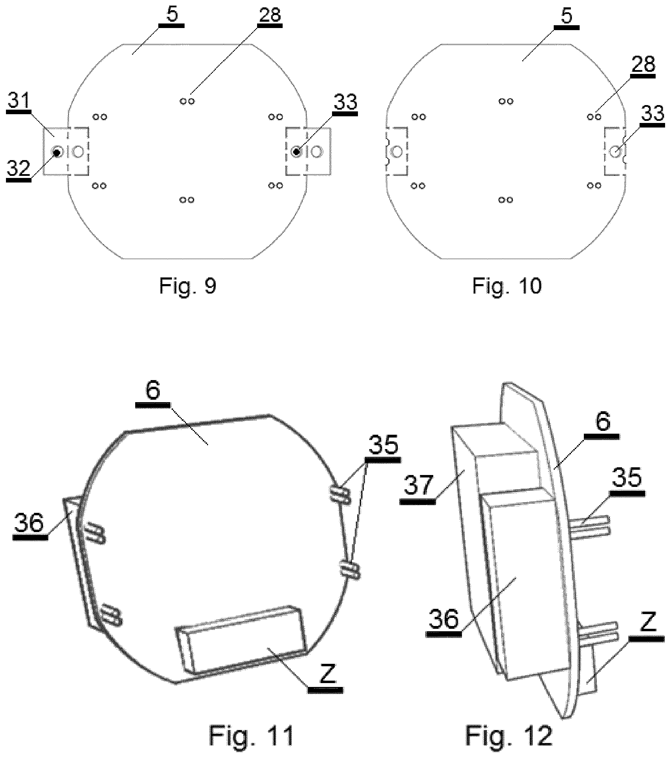

- Fig. 9 -: shows the microprocessor board front view with complete perforated breakable side outlets,
- Fig. 10 -: shows the microprocessor board front view with perforated breakable side outlets partially broke out,
- Fig. 11 -: shows the terminals board with power commutation switches and power supply unit perspective front view,
- Fig. 12 -: shows the terminals board with power commutation switches and power supply unit perspective side view.

The presented invention of wall switch module consists of integrated concrete backlighted and replaceable light guide panel **1,** sensors board **2,** decorative masking frame **3**, mounting bridge **4**, microprocessor board **5** and finally terminals board with power commutation switches and power supply unit. Light guide panel **1** comprise the dielectric front graphic layer **7,** inner light guide plate **8** and back reflective layer **9.** Front layer **7** has semitransparent graphic icons **10,** fully transparent window **11** for infrared receiver module **SP** and another fully transparent window **12** for ambient light sensor with infrared rangefinder **MS** as an integrated module. The light guide plate **8** has a form of dispersive dielectric sheet divided by a gaps, slits or slots filled with reflective material into six optical fiber light guide cells **13,** whereby the gaps filled with reflective material create the reflective side walls **14** of the light guide cells **13.** Moreover, there is a screw **15** on the back side of the light guide panel **1** for quick and easy connection with sensors board **2,** through-holes **16** for tricolor RGB LED diodes **D** soldered on sensors board **2,** through-hole **17** for ambient light sensor with rangefinder integrated module **MS** and through-hole **18** for infrared receiver module **SP** which are soldered on sensors board **2** too. Reflective back layer **9** has a hole **19** for a screw, through-holes **20** for LED diodes **D,** through-holes **21** for ambient light sensor with rangefinder **MS** and through-hole **22** for infrared receiver module **SP.** Front side of the sensors board **2** is soldered with six tricolor electroluminescent RGB LED diodes **D** in the number corresponding to the number of fiber-optic light guide cells **13** made in light guide panel, soldered with infrared receiver **SP** and integrated ambient light sensor with rangefinder **MS,** capacitive toch-proximity sensors **SZ** and the hole **23** coaxial with the mounting screw **15** for fastening the sensors board **2** to light guide panel **1**. Back side of sensors board **2** is soldered with touch-proximity sensors controller **SZ,** controller **25** of the tricolor RGB LEDs **D** and sockets **26** allowing connection with the microprocessor board. Microprocessor board **5** contains a microprocessor **27**, fastening rods **28** corresponding to the sockets **26** on sensors board **2,** connector **29** for communication with external devices as well as a connector **30** allowing connection to the terminals and power commutation switches board **6.** Furthermore, the microprocessor board **5** may have a radio communication module **M** and breakable perforated side outlets **31** with mounting holes **32** and **33** or side inlets **34** allowing easy interconnecting with the bridge **4** depending on the chosen market available bridge **4** type. Terminals and power commutation switches board **6** consists of rods **35** for connection with sockets **30** of microprocessor board **5,** power supply circuit **Z,** power cables connector **36** and a power commutation switches **37.** Any chosen commercially market available decorative masking frame **3** has a window **38** used for coaxially insertion both the backlighted light guide panel **1** and sensors board **2** stacked together. Between the frame **3** and the microprocessor board **5** there is a chosen commercially market available mounting bridge **4** having connecting elements **39.** External outline dimensions of backlighted light guide panel **1** and sensors board **2** are identical and exactly matched to the internal window **38** of the any chosen known and market available decorative masking frame **3.** As a primary user interface, touching or approaching the fingertip to the graphic icon **10** on front light guide panel **1,** user controls the device behavior and commands the herein presented touch wall switch. Alternatively, the touch wall switch may be controlled remotely using the second user interface in the form of a remote control generating wireless control commands. These wireless control signals are received by infrared receiver module **SP** and redirected directly to microprocessor **27** for decoding purposes and further execution. Each touch-proximity sensor **SZ** along with corresponding light guide cell **13** and graphic icon **10** form a separate logical channel controlling its power switch located in power commutation switch block **37**, allowing independent On/Off switching of chosen electrical appliance connected to power connector **36.** Functionality of each touch-proximity sensor **SZ** with its corresponding logical channel can be set up using the remote control to act in mode bistable, monostable, delayed monostable, bistable with controlled appliance acknowledge via communication connector **29,** 2-way mode or any abovementioned modes but with programmable time delay. In case a multiple said touch wall switches should be connected forming the network, connector **29** as a communication interface allows exchanging information across the network about On/Off state of any logical channel on any wall switch in the network as well as allows creation logical interactions between them, for instance by switching On/Off some channels on one touch wall switch when user touches a graphic icon **10** on another touch wall switch in the same network. A communication between the networked touch wall switches subject of discussion is possible also using the radio module **M.** Ambient light and rangefinder sensor **MS** allows the touch wall switch to determine the time of day or light intensity inside the room and detection of approaching hand towards the touch wall switch front control panel. When there is no light in the room, layer **7** with icons **10** will be slightly backlighted to make it easier for the user to find the positions of icons **10.**

### Markings list

- 1 -: Integrated backlighted replaceable light guide panel,
- 2 -: sensors board,
- 3 -: decorative masking frame,
- 4 -: mounting bridge,
- 5 -: microprocessor board,
- 6 -: terminals and power commutation switches board,
- 7 -: front dielectric layer of light guide panel with backlighted icons,
- 8 -: inner light guide plate,
- 9 -: back reflective layer of light guide panel,
- 10 -: semitransparent graphic icons,
- 11 -: transparent window in front dielectric layer for infrared receiver module,
- 12 -: transparent window for ambient light and rangefinder sensor module,
- 13 -: light guide cells,
- 14 -: reflective side walls of light guide cells,
- 15 -: light guide plate mounting screw for fastening to sensors board,
- 16 -: through holes for RGB LED diodes,
- 17 -: through hole for ambient light and rangefinder sensor,
- 18 -: through hole for infrared receiver module,
- 19 -: through hole in reflective layer for the screw,
- 20 -: through holes in reflective layer for RGB LED diodes,
- 21 -: through hole in reflective layer for ambient light and rangefinder module,
- 22 -: through hole in reflective layer for infrared receiver module,
- D -: electroluminescent LED diodes,
- MS -: ambient light and rangefinder sensor,
- M -: radio module,
- SP -: remote control signal infrared receiver module,
- SZ -: capacitive touch-proximity sensors,
- Z -: power supply unit,
- 23 -: screw hole in sensors board for mounting with the light guide panel,
- 24 -: touch-proximity sensors controller,
- 25 -: LED diodes controller,
- 26 -: sockets on sensor board for connecting with the microprocessor board,
- 27 -: microprocessor,
- 28 -: mounting rods on microprocessor board corresponding with sockets on sensors board,
- 29 -: connector for communication with external devices,
- 30 -: microprocessor board sockets for connecting with power commutation switches,
- 31 -: perforated side outlets of microprocessor board,
- 32 -: first alternate holes in side outlets for mounting with bridge,
- 33 -: second alternate holes in side outlets for mounting with bridge,
- 34 -: side inlets of microprocessor board,
- 35 -: mounting rods on with terminals and power commutation switches board,
- 36 -: connector for power cable connections,
- 37 -: power commutation switches block,
- 38 -: decorative masking frame inner window,
- 39 -: bridge mounting element.

## Claims

1. Set of boards of electronic multichannel touch wall switch composed of terminals board with power commutation switches and power supply unit, microprocessor main board with microprocessor, fitting bridge, decorative masking frame, sensors board with LED diodes and their controller, touch-proximity sensors with their controller as well as ambient light and rangefinder sensor module, light guide plate with back reflective layer and front dielectric layer with graphic backlighted icons, which said elements have the means to combine them together **characterised in that,** the light guide plate (**8**) is divided by a gaps, slits or slots creating required number of light guide cells (**13**), where said gap are filled with reflective material creating the side walls (**14**) of the light guide cells (**13**), whereby so constructed light guide plate (**8**) is stacked and integrated with back reflective layer (**9**) and front dielectric backlighted graphic layer (**7**) creating a solid fiber optic light guide panel (**1**), which along with the sensors board (**2**) are inserted into window (**38**) of the decorative masking frame (**3**), furthermore sensors board (**2**) contains an infrared light receiver (**SP**) module acquiring the remote control signals and the ambient light sensor (**MS**) integrated with the rangefinder made as a single integrated module using infrared wavelength band, whereas the main microprocessor board (**5**) has possibly breakable perforated side outlets (**31**) with mounting holes (**32**) and (**33**) facilitating the installation of the microprocessor (**5**) board to the decorative masking frame (**5**) by means of known commercially available mounting bridge (**4**), whereby the sensors board (**2**) and backlighted panel (**1**) both have an identical shape and outer size adjusted to the window (**38**) of the decorative masking frame (**3**).

2. Set of boards of electronic multichannel touch wall switch according to claim 1, wherein the microprocessor **5** has a connector **29** for communication with external devices.

3. Set of boards of electronic multichannel touch wall switch according to claim 1, wherein the microprocessor **5** has a radio module **M.**

4. Set of boards of electronic multichannel touch wall switch according to claim 1, wherein the electroluminescent LED diodes **D**, are tricolor LEDs.

5. Set of boards of electronic multichannel touch wall switch according to claim 1, wherein the surfaces of the optical fiber light guide cells **13** are laser engraved.
